Europäisches Patentamt

European Patent Office

Office européen des brevets

(19)

(11) Veröffentlichungsnummer: **0 339 407**
**A2**

(12) **EUROPÄISCHE PATENTANMELDUNG**

(21) Anmeldenummer: **89106779.5**

(22) Anmeldetag: **15.04.89**

(51) Int. Cl.⁴: **B60R 16/04**

(30) Priorität: **29.04.88 DE 3814551**

(43) Veröffentlichungstag der Anmeldung:
**02.11.89 Patentblatt 89/44**

(84) Benannte Vertragsstaaten:
**DE FR GB SE**

(71) Anmelder: **AUDI AG**
**Auto-Union-Strasse 1 Postfach 220**
**D-8070 Ingolstadt(DE)**

(72) Erfinder: **Brosinger, Reinhard**
**Beim Pfaffenacker 48**
**D-8070 Ingolstadt(DE)**
Erfinder: **Roth, Reiner**
**Peter-Dörfler-Strasse 7**
**D-8074 Gaimersheim(DE)**
Erfinder: **Kastner, Michael**
**Wagnerring 33**
**D-3180 Wolfsburg(DE)**

(74) Vertreter: **Le Vrang, Klaus**
**AUDI AG Postfach 220 Patentabteilung I/EQP**
**D-8070 Ingolstadt(DE)**

(54) **Verfahren zum Betreiben eines elektrischen Verbrauchers.**

(57) Um ein Entladen der Batterie bei Zuschalten eines Verbrauchers mit hoher Leistungsaufnahme in einem Kraftfahrzeug zu verhindern, wird während des Betriebs mit ausgeschaltetem Verbraucher ein Signal abgeleitet, das dem Ladezustand der Batterie entspricht. Bei eingeschaltetem Verbraucher wird dieses Signal um entsprechende Werte vermindert, bis ein unterer Grenzwert unterschritten ist. Dieser untere Grenzwert repräsentiert einen Entladezustand, der ein Abschalten des elektrischen Verbrauchers hoher Leistungsaufnahme notwendig macht.

EP 0 339 407 A2

## Verfahren zum Betreiben eines elektrischen Verbrauchers

Die Erfindung betrifft ein Verfahren zum Betreiben eines elektrischen Verbrauchers gemäß dem Oberbegriff des Anspruchs 1.

Weiterhin wird durch die Erfindung eine Schaltungsanordnung zur Durchführung des Verfahrens beschrieben.

Die Erfindung geht aus von der elektrischen Anlage in einem Kraftfahrzeug, bei der ein Generator eine Batterie lädt und gleichzeitig die Verbraucher mit Strom versorgt. Wenn die Summe der Stromaufnahme der Verbraucher die Stromabgabe des Generators übersteigt, wird der restliche benötigte Strom der Batterie entnommen.

Die Leistung eines Generators wird dabei darauf abgestellt, daß im wesentlichen der gesamte Strombedarf allein über die Stromabgabe des Generators gedeckt werden kann.

Mit der Einführung einer elektrisch beheizbaren Frontscheibe entsteht jedoch ein weiterer Verbraucher im Kraftfahrzeug, der verhältnismäßig selten eingeschaltet wird, dessen Leistungsaufnahme jedoch so hoch ist, daß die Leistungsabgabe des Generators die Gesamtstromversorgung im Kraftfahrzeug einschließlich der eingeschalteten beheizbaren Frontscheibe nicht mehr abdecken kann. Solange die Frontscheibe beheizt wird, wird somit Leistung der Batterie entnommen.

Dies kann dazu führen, daß der Ladezustand der Batterie soweit absinkt, daß nach Abschalten den Kraftfahrzeuges ein Wiederanlassen nicht mehr möglich ist, da die Restladung der Batterie dazu nicht mehr ausreicht.

Aufgabe der Erfindung ist, ein Verfahren zum Betreiben der elektrischen Verbraucher anzugeben, bei dem sichergestellt ist, daß die Batterie nicht zu stark entladen wird.

Dabei erweist sich die Möglichkeit, die Ladung der Batterie zu messen, als zu aufwendig und vom Ergebnis her nicht genau genug.

Die Aufgabe wird mit einfacheren Mitteln durch den Hauptanspruch gelöst.

Erfindungsgemäß ist vorgesehen, daß der Betriebszustand des Fahrzeugs mit ausgeschaltetem elektrischem Verbraucher hoher Leistungsaufnahme, beispielsweise der heizbaren Frontscheibe, ermittelt wird. Da in diesem Betriebszustand die Stromaufnahme der restlichen Verbraucher allein durch die Stromabgabe des Generators gedeckt werden kann, wird unter diesen Betriebszuständen die Batterie nicht entladen, sondern gegebenenfalls sogar nachgeladen.

Wenn umgekehrt der elektrische Verbraucher hoher Leistungsaufnahme zugeschaltet wird, reicht die Stromabgabe des Generators nicht mehr, die Batterie wird entladen.

Aus den Betriebszeiten der letzten Fahrten ohne zugeschalteten elektrischen Verbraucher wird ermittelt, welche Ladung in der Batterie noch zur Verfügung steht. Für die Zeitdauer des eingeschalteten elektrischen Verbrauchers hoher Leistungsaufnahme wird von dieser Ladung ein bestimmter Wert abgezogen, der die entnommene Ladung der Batterie widerspiegelt. Sinkt die dadurch verbleibende Restladung der Batterie unter einen bestimmten Wert, wird der Verbraucher mit hoher Leistungsaufnahme abgeschaltet.

Weiterhin wird durch die Erfindung eine Schaltung angegeben, mit der das beschriebene Verfahren durchgeführt werden kann.

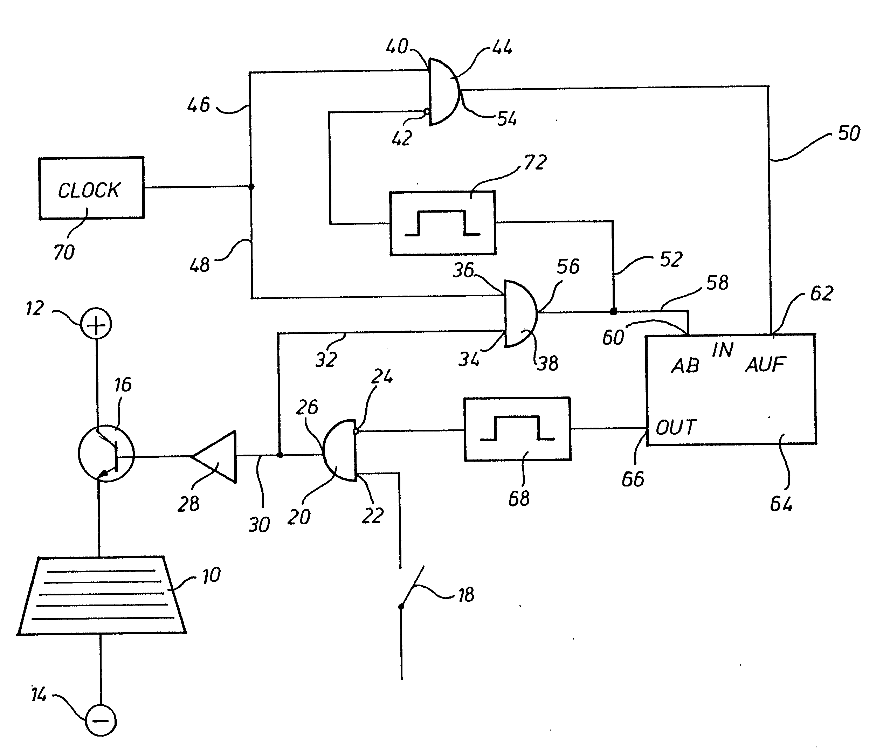

Weitere Einzelheiten werden aus der Figur deutlich, die im folgenden beschrieben ist:

Die einzige Figur zeigt den Aufbau einer erfindungsgemäßen Schaltung.

Mit dem Bezugszeichen 10 ist eine elektrisch heizbare Frontscheibe bezeichnet, die an ihrer einen Seite an eine positive Spannungsversorgung 12 und an ihrer anderen Seite an eine negative Spannungsversorgung 14 angeschlossen ist. Durch einen Schalter 16, der hier als Transistor dargestellt ist, kann die positive Spannung 12 der Frontscheibe 10 zugeführt werden.

Eine zugehörige Logikschaltung sorgt dafür, daß die Batterie nicht zu stark entladen wird, da die Stromaufnahme der Frontscheibe 10 die mögliche Stromabgabe des Generators übersteigt und somit die Batterie zusätzlich beansprucht.

Die Schaltung ist folgendermaßen aufgebaut: Die Basis des Transistors 16, dessen Kollektor mit der positiven Spannungsquelle 12 und dessen Emitter mit der Frontscheibe 10 verbunden ist, wird angesteuert über den Ausgang 26 eines AND-Gatters 20. Dieser Ausgang 26 führt über eine Leitung 30 zu einer Treiberstufe 28, deren Ausgang auf die Basis des Transistors 16 geführt ist. Der eine Eingang 22 des AND-Gatters 20 führt zu einem Ein- und Ausschalter 18. Dieser Ein- und Ausschalter 18 dient zum Einschalten der heizbaren Frontscheibe 10, bei geschlossenem Schalter 18 liegt ein H-Signal am Eingang 22 des AND-Gatters 20.

Der andere Eingang 24 des AND-Gatters 20 ist negiert mit dem Ausgang eines Monoflops 68 verbunden, das Monoflop 68 erhält ein Eingangssignal vom Ausgang 66 eines Auf-Ab-Zählers 64.

Der Ausgang des AND-Gatters 20 ist gleichzeitig über eine Leitung 32 mit dem Eingang 34 eines AND-Gatters 38 verbunden. Der andere Eingang 36 dieses AND-Gatters 38 erhält über eine Leitung 48 das Signal einer Takteinheit 70.

Der Ausgang 56 dieses AND-Gatters 38 ist über eine Leitung 58 mit dem Abwärtseingang 60 des Auf-Ab-Zählers 64 verbunden. Gleichzeitig ist der Ausgang 56 des AND-Gatters 38 über eine Leitung 52 negiert an den Eingang 42 eines weiteren AND-Gatters 44 gelegt, dessen anderer Eingang 40 über eine Leitung 46 ebenfalls das Taktsignal von der Takteinheit 70 erhält. Der Ausgang 54 des AND-Gatters 54 ist über eine Leitung 50 auf den Aufwärts-Zähl-Eingang 62 des Auf-Ab-Zählers 64 geführt.

Die Funktion der beschriebenen Schaltung ist wie folgt: Der Zähler 64 ist mit einem nicht flüchtigen Speicher versehen, der auch bei Abstellen des Kraftfahrzeuges, wenn die Schaltung nicht mehr mit Strom versorgt ist, seinen Zählstand behält. Es wird für den Betrieb davon ausgegangen, daß der Zähler einen beliebigen Zählstand hat, der von Null verschieden ist. Der Sonderfall des Zählstandes Null wird weiter unten beschrieben.

Der Ausgang 66 des Zählers 64 führt, solange der Zählerstand von Null veschieden ist, kein Signal, so daß auch das Monoflop 68 nicht gestartet wird. Da das vom Monoflop 68 abgegebene Signal am Eingang 24 des AND-Gatters 20 negiert wird, liegt somit mit dem Einschalten der Stromversorgung am Eingang 24 des AND-Gatters 20 eine logische Eins.

Wird nun der Schalter 18 geschlossen, um die heizbare Frontscheibe 10 in Betrieb zu nehmen, erscheint auch am Eingang 22 des AND-Gatters 20 eine logische Eins, und somit springt der Ausgang 26 des AND-Gatters 20 auf logisch Eins oder H, die entsprechende Treiberstufe 28 steuert die Basis des Transistors 16 an. Der Transistor 16 öffnet, und es fließt Strom von der positiven Spannungsquelle 12 durch die heizbare Frontscheibe zur negativen Spannungsquelle 14.

Gleichzeitig wird die logische Eins vom Ausgang 26 des AND-Gatters 20 über die Leitung 32 auf den Eingang 34 des AND-Gatters 38 gelegt. Der andere Eingang des AND-Gatters 36 erhält über die Leitung 48 die Taktimpulse der Takteinheit 70, so daß die Taktfrequenz auch am Ausgang 56 des AND-Gatters 38 erscheint und somit über die Leitung 58 dem Abwärts-Zähl-Eingang 60 des Zählers 64 zugeführt wird.

Der Ausgang 56 steuert gleichzeitig über die Leitung 52 das Monoflop 72 an. Die Impulsdauer des von dem Monoflop 72 abgegebenen Impulses ist größer als die Taktfrequenz, die von der Takteinheit 70 abgegeben wird. Damit wird durch die am Ausgang 56 des AND-Gatters 38 erscheinenden Impulse das Monoflop 72 angesteuert und erhält, bevor der erste abgegebene Impuls ausgelaufen ist, bereits einen neuen Triggerimpuls, so daß am Ausgang des Monoflops 72 eine logische Eins ansteht. Dieses Signal wird am Eingang 42 des AND-Gatters negiert, so daß der Ausgang 54 des AND-Gatters 44 auf logisch Null liegt, über die Leitung 50 wird somit an den Aufwärts-Zähl-Eingang 62 kein Signal geführt.

Somit wird der Zähler 64 im Takt der von der Takteinheit 70 abgegebenen Impulse abwärts gezählt.

Als Ergebnis zählt der Zähler abwärts, solange die heizbare Frontscheibe 10 eingeschaltet ist.

Erreicht nun der Zählstand des Zählers 64 den Wert Null, erscheint am Ausgang 66 eine logische Eins, die das Monoflop 68 ansteuert. Das Monoflop 68 hat eine verhältnismäßig lange Impulszeit, die typischerweise auf mehrere Minuten eingestellt wird.

Sobald der Zähler als Zählstand Null erreicht hat, wird somit das Monoflop 68 angesteuert und gibt einen entsprechenden Puls an seinem Ausgang ab. Dieser Impuls wird am Eingang 24 des AND-Gatters 20 negiert, so daß der Ausgang 26 des AND-Gatters 20 auf Null abfällt, wodurch der Transistor 16 gesperrt wird, die heizbare Frontscheibe 10 wird abgeschaltet.

Gleichzeitig wird die logische Null über die Leitung 32 dem Eingang 34 des AND-Gatters 38 zugeführt, wodurch der Ausgang 56 des AND-Gatters 38 auf Null abfällt.

Damit läuft das Monoflop 72 aus, da es nicht getriggert wird, somit bleibt der Ausgang des Monoflops 72 auf logisch Null. Somit steht am negierten Eingang 42 des AND-Gatters 44 eine logische Eins, das AND-Gatter 44 wird damit durch die Taktimpulse, die über die Leitung 46 am Eingang 40 erscheinen, taktweise durchgeschaltet, die Signaltaktfolge erscheint damit am Ausgang 54 und wird über die Leitung 50 dem Aufwärtseingang 62 des Auf-Ab-Zählers 64 zugeführt, für die Dauer der Verriegelung des AND-Gatters 20 und somit der Abschaltung der heizbaren Frontscheibe 10 zählt der Zähler 64 aufwärts.

Damit fällt der Ausgang 66 des Zählers 64 auf Null ab, und bei geschlossenem Schalter 18 wird nach Abfall des Monoflops 68 der Transistor 16 wieder durchgeschaltet, wie oben beschrieben, und die Frontscheibe 10 wieder eingeschaltet.

Es wird damit erreicht, daß bei eingeschaltetem Schalter 18 nach einer gewissen Betriebszeit, die durch den Zählerstand repräsentiert ist, die Frontscheibe 10 abge schaltet wird. Für eine "Erholungszeit", die durch die Signallänge des von dem Monoflop 68 gegebenen Impulses bestimmt wird, kann die Batterie wieder aufgeladen werden, anschließend wird die Frontscheibe wieder zugeschaltet.

Ist der Schalter 18 jedoch geöffnet, ist das AND-Gatter 20 auf jeden Fall am Ausgang auf dem Wert Null, da der eine Eingang 22 kein Signal erhält. In diesem Falle liegt der Eingang 34 des AND-Gatters 38 ständig auf Null, der Zähler 64 zählt aufwärts.

Der maximale Zählwert des Zählers 64 ist so eingerichtet, daß er einem maximalen Ladezustand der Batterie entspricht. Über diesen Wert hinaus wird nicht weiter aufwärts gezählt, da auch die Batterie über ihren maximalen Ladezustand hinaus nicht geladen werden kann.

Während der Dauer des Abwärtszählens von diesem Maximalzählwert würde die Stromentnahme aus der Batterie tolleriert, anschließend wird die heizbare Frontscheibe 10 abgeschaltet.

Ist auf Grund der vorherigen Betriebsweisen, beispielsweise für eine gewisse Zeitdauer ebenfalls mit eingeschalteter Frontscheibe 10, der Zählstand niedriger, ist entsprechend die Entnahme aus der Batterie, die durch die Logik zugelassen wird, geringer.

Die Schaltung kann selbstverständlich jedem Detail angepaßt werden. Insbesondere ist es denkbar, daß nicht eine einzige Takteinheit 70, die sowohl das AND-Gatter 44 fürs Aufwärtszählen als auch das AND-Gatter 38 fürs Abwärtszählen versorgt, vorgesehen ist, sondern daß die Impulsfolge, die das Aufwärtszählen besorgt, abweichend ist von der Impulsfolge, die das Abwärtszählen besorgt. Mit anderen Worten, den Eingängen 40 bzw. 36 der AND-Gatter 44 bzw. 38 werden unterschiedliche Taktfrequenzen zugeführt.

Die Dauer des Abschaltens der heizbaren Frontscheibe 10 kann durch die Impulslänge des Monoflops 68 eingestellt werden.

In einer Weiterbildung ist es denkbar, die Taktfrequenz, die den Zähleingängen 60 und 62 des Zählers 64 jeweils zugeführt werden, je in Abhängigkeit von den restlichen Verbrauchern zu verändern, so daß bei zusätzlich eingeschalteten Verbrauchern mit einer geringeren Frequenz aufwärts gezählt oder mit schnellerer Frequenz abwärts gezählt wird. Der in den Zähler 64 einzuschreibende Maximalwert kann ebenfalls abhängig gemacht werden von weiteren Parametern, beispielsweise Batteriegröße, Temperatur, Alterungszustand der Batterie u. ä.

Es sind auch andere schaltungstechnische Verwirklichungen für das erfindungsgemäße Verfahren denkbar. Die Fahrzyklen mit abgeschalteter Frontscheibe lassen sich in einen Speicher einschreiben, und in einer Multiplikationsstufe wird der Speicherinhalt, als Zeit ausgedrückt, mit dem freien Reststrom, der von dem Generator nach Abzug der übrigen Verbraucher abgegeben wird, multipliziert.

Ebenfalls wird in einem zweiten Speicher die Zeitdauer des Fahrens mit eingeschalteter heizbarer Frontscheibe ermittelt, und mit einer Maximalstromabgabe multipliziert. Aus diesen beiden Werten wird eine Differenz gebildet und in einem Komperator mit einem Mindestwert verglichen. Bei Unterschreiten des Mindestwertes wird der Verbraucher abgeschaltet.

## Ansprüche

1. Verfahren zum Betreiben eines elektrischen Verbrauchers hoher Leistungsaufnahme in einem Kraftfahrzeug, wobei der Ladezustand der Batterie berücksichtigt wird, **gekennzeichnet durch** folgende Schritte:

    a) es wird die Zeitdauer des Betriebs des Kraftfahrzeuges ohne Einschaltung des elektrischen Verbrauchers hoher Leistungsaufnahme erfaßt,

    b) es wird aus dieser Zeitdauer ein für den Ladezustand aussagekräftiger Wert abgeleitet,

    c) dieser Wert wird während des Zuschaltens des elektrischen Verbrauchers hoher Leistungsaufnahme modifiziert,

    d) bei Erreichen eines Schwellwertes für den modifizierten Wert wird der Verbraucher abgeschaltet.

2. Schaltungsanordnung zur Durchführung des Verfahrens nach Anspruch 1, **gekennzeichnet durch** einen Zähler (64), der ohne den eingeschalteten Verbraucher (10) hoher Leistungsaufnahme in eine erste Richtung bis zu einem Grenzwert zählt, und mit eingeschaltetem Verbraucher (10) mit hoher Leistungsaufnahme in umgekehrter Richtung bis zu einem zweiten Grenzwert zählt und bei Erreichen des zweiten Grenzwertes den Verbraucher (10) hoher Leistungsaufnahme abschaltet.

EP 0 339 407 A2